# EUROPÄISCHE PATENTSCHRIFT

(11) **EP 3 794 634 B1**
(45) Veröffentlichungstag und Bekanntmachung des Hinweises auf die Patenterteilung: **31.05.2023**
(21) Anmeldenummer: 19723738.1
(22) Anmeldetag: 06.05.2019
(51) Int. Cl.: H01L 21/67, C25F 3/12, H01L 21/683, H01L 21/677, C25F 7/00

(54) **VORRICHTUNG UND VERFAHREN ZUM EINSEITIGEN ÄTZEN EINER HALBLEITERSCHICHT EINES WERKSTÜCKS**
APPARATUS AND METHOD FOR ONE-SIDED ETCHING OF A SEMICONDUCTOR LAYER OF A WORKPIECE
APPAREIL ET MÉTHODE POUR LA GRAVURE MONO-FACE D'UNE COUCHE SEMICONDUCTEUR D'UN SUBSTRAT

(30) Priorität: 17.05.2018 DE 102018111858
(43) Veröffentlichungstag der Anmeldung: 24.03.2021
(73) Patentinhaber: Nexwafe GmbH, 79108 Freiburg (DE)
(72) Erfinder: REBER, Stefan, 79194 Gundelfingen (DE); SCHILLINGER, Kai, 79106 Freiburg (DE); REICHHART, Benjamin, 79312 Emmendingen-Wasser (DE); MILENKOVIC, Nena, 79276 Reute (DE)
(74) Vertreter: LBP Lemcke, Brommer & Partner Patentanwälte mbB
(86) Internationale Anmeldenummer: PCT/EP2019/061548
(87) Internationale Veröffentlichungsnummer: WO 2019/219430

(56) Entgegenhaltungen:
- DE-A1-102007 020 449
- JP-A- H05 326 488
- JP-A- 2003 017 464
- US-A- 5 000 827
- US-A1- 2002 127 956

## Beschreibung

Die vorliegende Erfindung betrifft eine Vorrichtung und ein Verfahren zum einseitigen Ätzen einer Halbleiterschicht eines Werkstücks.

Bei der Verarbeitung von Halbleiterschichten, insbesondere bei der Herstellung von großflächigen Halbleiterbauelementen, wie beispielsweise photovoltaischen Solarzellen, ist häufig ein Verarbeiten einer Seite der Halbleiterschicht mittels Ätzen wünschenswert. Hierzu kann die nicht zu ätzende Seite mit einer Ätz-Schutzschicht versehen werden, sodass in einem nachfolgenden Ätzvorgang lediglich die nicht von der Schutzschicht bedeckte Seite bearbeitet wird. Ein derartiges Vorgehen ist jedoch verfahrensaufwendig, da die Schutzschicht aufgebracht und wieder abgenommen werden muss.

Es sind daher Verfahren bekannt, bei welchen im Wesentlichen lediglich die zu ätzende Seite der Halbleiterschicht mit einem Elektrolyten benetzt wird. Mittels einer Stromquelle, typischerweise einer Konstantstromquelle, wird ein Ätzstrom zwischen dem Elektrolyten und der Halbleiterschicht erzeugt, sodass ein einseitiges Ätzen erfolgt.

Solche Verfahren und Vorrichtungen sind aus DE 10 2013 219 886 A1 und DE 10 2015 121 636 A1 bekannt. Hierbei wird mittels einer Transportvorrichtung das Werkstück, welches eine Halbleiterschicht mit einer zu ätzenden Seite aufweist, derart über einen Elektrolyten in einer Ätzkammer bewegt, dass im Wesentlichen nur die dem Elektrolyten zugewandte Seite der Halbleiterschicht mit dem Elektrolyten benetzt wird. Aus DE 10 2013 219 886 A1 ist ein Verfahren bekannt, bei welchem das Werkstück an der nicht zu ätzenden Oberfläche über eine Kontakteinheit elektrisch mittels einer Anode kontaktiert wird.

Die vorgenannten Verfahren sind bereits in einem Inline-Prozess einsetzbar. Es besteht jedoch für eine Verwendung in der industriellen Fertigung Bedarf, die Qualität des Ätzvorgangs zu verbessern. Insbesondere bei Verwendung der vorgenannten einseitigen Ätzverfahren zum Porosifizieren einer Oberfläche der Halbleiterschicht, um die Halbleiterschicht als Saatträger für eine nachgelagerte Halbleiterwaferherstellung zu verwenden, ist eine hohe Qualität, insbesondere Homogenität des Ätzvorgangs auch im Inline-Verfahren notwendig.

Der vorliegenden Erfindung liegt daher die Aufgabe zugrunde, die Qualität der vorbekannten einseitigen Ätzverfahren mittels elektrochemischen Ätzen zu verbessern.

Gelöst ist diese Aufgabe durch eine Vorrichtung gemäß Anspruch 1 sowie durch ein Verfahren gemäß Anspruch 14. Vorteilhafte Ausgestaltungen finden sich in den abhängigen Unteransprüchen.

Die erfindungsgemäße Vorrichtung ist bevorzugt zum Durchführen des erfindungsgemäßen Verfahrens ausgebildet, insbesondere einer bevorzugten Ausführungsform hiervon. Das erfindungsgemäße Verfahren ist bevorzugt zum Durchführen mittels der erfindungsgemäßen Vorrichtung ausgebildet, insbesondere einer bevorzugten Ausführungsform hiervon.

Die erfindungsgemäße Vorrichtung zum einseitigen Ätzen einer Halbleiterschicht eines Werkstücks weist zumindest ein Ätzbecken zur Aufnahme eines Elektrolyten zur Ausbildung eines Ätzbades auf sowie eine erste Elektrode, welche zur elektrischen Kontaktierung des sich bei Benutzen in dem Ätzbecken befindenden Elektrolyten angeordnet ist, zumindest eine zweite Elektrode, welche zur mittelbaren oder unmittelbaren elektrischen Kontaktierung der Halbleiterschicht angeordnet ist, zumindest eine elektrische Stromquelle, welche mit der ersten und der zweiten Elektrode zum Erzeugen eines Ätzstroms elektrisch leitend verbunden ist und zumindest eine Transportvorrichtung zum Transport des Werkstücks relativ zu dem Ätzbecken, derart, dass nur eine zu ätzende Ätzseite der Halbleiterschicht durch den sich bei Benutzung in dem Ätzbecken befindenden Elektrolyten benetzbar ist.

Die Erfindung ist in der Erkenntnis des Anmelders begründet, dass bei den vorbekannten Vorrichtungen auf der dem Elektrolyten abgewandten Seite des Werkstücks entweder nasschemische Kontaktierungen verwendet wurden, welche zwar einen homogenen Kontakt mit niedrigem Übergangswiderstand zur Halbleiterschicht ermöglichen, allerdings nur mit großem Aufwand in eine Durchlaufanlage zu integrieren sind. Insbesondere zeigen Untersuchungen des Anmelders, dass bei Verwendung in einer Durchlaufanlage bei nasschemischer Kontaktierung mittels der zweiten Elektrode im Betrieb häufig Leckströme am Rand des Werkstücks auftreten, die zu einem inhomogenen Ätzvorgang führen. Aus DE 10 2013 219 886 A1 ist bekannt, in einer Durchlaufanlage eine Kontaktierung der zweiten Elektrode flüssigkeitsfrei mittels eines mitlaufenden Kontaktes oder eines Schleifkontaktes zu realisieren. Untersuchungen des Anmelders zeigen, dass im Zusammenspiel mit dem verwendeten Transportband bei solchen Kontaktierungen ebenfalls inhomogene Ätzvorgänge auftreten können.

Bei der erfindungsgemäßen Vorrichtung ist daher wesentlich, dass die Transportvorrichtung ein Unterdruck-Halteelement für das Werkstück aufweist und das Unterdruck-Halteelement zum Anordnen des Werkstücks an einer der Ätzseite gegenüberliegenden Halteseite des Werkstücks mittels Unterdruck ausgebildet ist. Weiterhin ist die zweite Elektrode derart an dem Unterdruck-Halteelement angeordnet, sodass bei an dem Unterdruck-Halteelement angeordnetem Werkstück eine Kontaktierung der Halteseite des Werkstücks mittels der zweiten Elektrode erfolgt.

Die vorbeschriebene Fehleranalyse des Anmelders bei bisherigen Vorrichtungen führte zur Entwicklung der erfindungsgemäßen Vorrichtung, bei welcher mittels des Unterdruck-Halteelementes zwei wesentliche Fehlerquellen ausgeschlossen oder zumindest deren Einfluss verringert werden können: Durch Ausbildung des Halteelementes als Unterdruck-Halteelement erfolgt ein Halten des Werkstücks somit zumindest im Wesentlichen, bevorzugt ausschließlich, durch das Unterdruck-Halteelement und somit an der der Ätzseite gegenüberliegenden Halteseite des Werkstücks. Es kann somit ein sicherer Halt realisiert werden, ohne Kontakt des Halteelements zu dem Elektrolyten. Weiterhin bietet die Ausgestaltung des Halteelements als Unterdruck-Halteelement die Möglichkeit, mittels des Unterdrucks gleichzeitig einen Anpressdruck des Werkstücks an die zweite Elektrode zu realisieren und somit eine homogene Kontaktierung zu begünstigen. Darüber hinaus sind bei der erfindungsgemäßen Vorrichtung Auflageelemente wie beispielsweise Transportbänder für das Werkstück im Elektrolyten nicht notwendig, sodass an der zu ätzenden Seite Inhomogenitäten durch Auflagepunkte auf solche Transportbänder vermieden werden können.

Die erfindungsgemäße Vorrichtung ermöglicht somit ein einseitiges elektrochemisches Ätzen einer Halbleiterschicht eines Werkstücks im Inline-Betrieb mit dennoch hoher Qualität, insbesondere einer guten Homogenität des Ätzvorgangs an der Ätzseite.

Das einseitige Ätzen mittels des erfindungsgemäßen Verfahrens und der erfindungsgemäßen Vorrichtung erfolgt bevorzugt, indem im Wesentlichen nur die zu ätzende Seite der Halbleiterschicht mit Elektrolyt benetzt wird. Es liegt im Rahmen der Erfindung, dass auch der Randbereich und Teile der dem Elektrolyten abgewandten Seite des Werkstücks zumindest zweitweise mit Elektrolyten überspült sind. Es erfolgt jedoch bevorzugt ein trockener Kontakt zwischen der zweiten Elektrode und dem Werkstück. Vorteilhafterweise weist die erfindungsgemäße Vorrichtung daher zumindest ein Trennmittel auf, um einen Kontakt zwischen Elektrolyt und Werkstück zumindest im Kontaktbereich zwischen Werkstück und zweiter Elektrode zu verhindern.

Das Halteelement kann ein Trägerelement aufweisen, auf welchem die Halbleiterschicht angeordnet ist. Insbesondere kann das Trägerelement elektrisch leitend sein, sodass das Trägerelement mittels der zweiten Elektrode elektrisch kontaktiert wird. Ebenso können zusätzliche stromleitende Elemente vorgesehen sein, um eine elektrisch leitende Verbindung der mit den stromleitenden Elementen verbundenen zweiten Elektrode und der Halbleiterschicht zu gewährleisten. In typischen Anwendungsfällen ist das Werkstück als einstückige Halbleiterschicht, beispielsweise Halbleiterwafer, insbesondere Siliziumwafer, ausgebildet.

Die eingangs genannte Aufgabe ist ebenfalls durch ein erfindungsgemäßes Verfahren zum einseitigen Ätzen einer Halbleiterschicht eines Werkstücks gelöst, wobei die Halbleiterschicht an einer zu ätzenden Ätzseite mit einem Elektrolyten benetzt wird. Der Elektrolyt wird mit einer ersten Elektrode und das Werkstück an einer dem Elektrolyten abgewandten Seite mit einer zweiten Elektrode elektrisch kontaktiert. Zwischen den Elektroden wird ein Ätzstrom ausgebildet. Wesentlich ist, dass während des Ätzvorgangs das Werkstück ausschließlich an einer der Ätzseite gegenüberliegenden Halteseite mittels Unterdruck gehalten und an die zweite Elektrode angedrückt wird.

Hierdurch ergeben sich die zu dem erfindungsgemäßen Verfahren genannten Vorteile.

Um eine Inhomogenität durch Auflagepunkte mit Halteelementen an der Ätzseite zu vermeiden, ist die Vorrichtung bevorzugt ausgebildet, während des Ätzvorgangs das Werkstück ausschließlich mittels des Unterdruck-Halteelementes zu halten.

Vorteilhafterweise wird das Werkstück mittels Unterdruck mit einem Druck im Bereich 10 Pa bis 50.000 Pa, bevorzugt im Bereich 200 Pa bis 2000 Pa an die zweite Elektrode angedrückt.

Die erfindungsgemäße Vorrichtung weist bevorzugt ein Unterdruckmittel auf, welches mit dem Unterdruck-Halteelement zusammenwirkend ausgebildet ist, um einen Anpressdruck des Werkstücks an die zweite Elektrode zu erzeugen, insbesondere bevorzugt im Bereich 10 Pa bis 50.000 Pa, bevorzugt im Bereich 200 Pa bis 2000 Pa, um die vorgenannten Vorteile zu erzielen.

Hierdurch sind ein sicherer Halt sowie ein guter elektrischer Kontakt begünstigt. Bei der vorliegenden Erfindung wird somit durch das Unterdruck-Halteelement ein Anliegen des Werkstücks mit der Halteseite an der zweiten Elektrode gewährleistet. Es kann daher auf verfahrensaufwendige nasschemische Kontaktierungsarten bei der zweiten Elektrode verzichtet werden. Vorteilhafterweise kontaktiert daher während des Ätzvorgangs die zweite Elektrode die Halteseite des Werkstücks trocken.

Um einen homogenen Ätzvorgang zu begünstigen, wird das Werkstück an der Halteseite bevorzugt großflächig mittels der zweiten Elektrode elektrisch leitend kontaktiert. Vorteilhafterweise kontaktiert die zweite Elektrode während des Ätzvorgangs daher eine Fläche im Bereich von 100 cm² bis 2 m², insbesondere 150 cm² bis 1600 cm² der Halteseite des Werkstücks, bei typischen Werkstückabmessungen von 15,7 cm x 15,7 cm.

Die erfindungsgemäße Vorrichtung weist daher bevorzugt eine als Flächenelektrode ausgebildete zweite Elektrode auf. Insbesondere ist es vorteilhaft, dass die zweite Elektrode zur Bedeckung einer Fläche von zumindest 100 cm², insbesondere zumindest 150 cm², weiter bevorzugt zumindest 200 cm² der Halteseite des Werkstücks ausgebildet ist. Hierdurch werden die zuvor genannten Vorteile erzielt.

Wie zuvor beschrieben, ist es bei der vorliegenden Erfindung nicht notwendig, an der Ätzseite ein Transportsystem vorzusehen. Insbesondere ist ein aus dem Stand der Technik bekanntes Förderbandsystem, welches sich im Elektrolyten nahe der Oberfläche des Elektrolyten befindet, nicht notwendig.

Es ist jedoch vorteilhaft, ein Sicherheits-Transportsystem im Elektrolyten vorzusehen, sodass in einem Störfall, bei welchem sich das Werkstück fehlerhaftweise von dem Unterdruck-Halteelement löst, insbesondere bei welchem das Werkstück zerbricht, einen Abtransport des Werkstücks bzw. von Teilen des Werkstücks zu gewährleisten.

Vorteilhafterweise weist die Vorrichtung daher ein Sicherheits-Transportsystem auf, welches insbesondere bevorzugt zumindest ein Auffangelement umfasst. Das Sicherheits-Transportsystem ist dabei vorteilhafterweise so ausgebildet, dass das Auffangelement während des Ätzvorgangs im Elektrolyten synchron zu dem Unterdruck-Halteelement zu bewegen. Bei dieser vorteilhaften Ausführungsform ist somit gewährleistet, dass ein sich lösendes Werkstück oder Teile hiervon im Fehlerfall nicht im Elektrolyten verbleiben, sondern abtransportiert und beispielsweise in einen Ausschussbehälter mittels des Sicherheits-Transportsystems ausgegeben werden können.

Das Sicherheits-Transportsystem kann in an sich bekannter Weise als Förderband ausgebildet sein. Bevorzugt ist das Sicherheits-Transportsystem derart ausgebildet, dass während des Ätzvorgangs kein Kontakt zwischen Werkstück und Auffangelement besteht, insbesondere bei unbeschädigtem Werkstück.

Hiermit ist im Regelfall somit eine Inhomogenität des Ätzvorgangs durch Auflagepunkte an der Ätzseite im Elektrolyten ausgeschlossen. Zusätzlich ist jedoch im Fehlerfall gewährleistet, dass das Werkstück oder ein Bruchstück hiervon in Kontakt mit dem Sicherheits-Transportsystem kommt und wie zuvor beschrieben abtransportiert wird.

Das Sicherheitstransportsystem ist somit bevorzugt ausgebildet, ein vom Unterdruck-Halteelement abfallendes Werkstück oder Teile hiervon aus dem Elektrolyten abzutransportieren.

In einer vorteilhaften Ausführungsform ist das Sicherheitstransprotsystem ausgebildet, ein abgefallenes Werkstück oder Bruchstücke hiervon synchron zu der Bewegung des Unterdruck-Halteelementes zu fördern. Hierdurch ergibt sich der Vorteil, dass das Risiko eines Wechselwirkens des abgefallenen Werkstücks oder von Bruchstücken hiervon mit vorangehenden oder nachfolgenden Unterdruck-Halteelementen verringert wird.

Ebenso liegt es im Rahmen der Erfindung, dass das Sicherheitstransportsystem für einen Transport entgegen der Transportrichtung des Werkstücks durch das Hubelement oder schräg oder senkrecht hierzu ausgebildet ist.

Das Sicherheitstransportsystem umfasst bevorzugt zumindest eine Kette, Rolle und/oder Netz.

Das Sicherheits-Transportsystem weist in einer bevorzugten Ausführungsform zumindest ein Auffangelement, insbesondere einen Auffangkorb oder ein Auffangnetz, auf, welches bevorzugt zumindest die Fläche des Werkstücks abdeckt. Hierdurch ist gewährleistet, dass auch bei einem Zerbrechen des Werkstücks die Bruchstücke durch das Sicherheits-Transportsystem abtransportiert werden. Bevorzugt weist das Sicherheits-Transportsystem Auffangelement für das Werkstück und/oder Bruchstücke des Werkstücks auf.

Das Sicherheitstransportsystem ist zumindest mit den das Werkstück oder Bruchstücke hiervon transportierenden Elementen bevorzugt unterhalb der Oberfläche des Elektrolyten angeordnet, bevorzugt mit einem Abstand von zumindest 3 mm, insbesondere zumindest 5 mm, bevorzugt zumindest 1 cm zu der Oberfläche des Elektrolyten.

Die Auffangelemente bewegen sich bevorzugt im Elektrolyten unterhalb der Oberfläche des Elektrolyten, bevorzugt mit einem Abstand von zumindest 3 mm, insbesondere zumindest 5 mm, bevorzugt zumindest 1 cm zu der Oberfläche des Elektrolyten.

Untersuchungen des Anmelders zeigten, dass inhomogene Ströme am Rand des Werkstücks zwischen dem nasschemischen Kontakt an der Ätzseite der Halbleiterschicht und dem trockenen Kontakt mittels der zweiten Elektrode an der Halteseite des Werkstücks ein weiterer Grund für inhomogene Ätzergebnisse sind. Vorteilhafterweise wird daher die durch die zweite Elektrode bedeckte Fläche kleiner gewählt als die zu ätzende Fläche, das heißt die Fläche der Ätzseite der Halbleiterschicht. Insbesondere ist es vorteilhaft, dass die zweite Elektrode mit einem Randabstand an der Halteseite des Werkstücks angeordnet ist, insbesondere mit einem umlaufenden Randabstand. Bevorzugt kontaktiert die zweite Elektrode die Halteseite des Werkstücks daher mit einem Randabstand im Bereich von 5 mm bis 20 mm zu dem Rand des Werkstücks, insbesondere zu dem Rand der Halteseite, insbesondere bevorzugt mit einem umlaufenden Randabstand, bevorzugt in dem genannten Bereich.

Untersuchungen des Anmelders zeigen, dass der nachfolgend beschriebene Aufbau der zweiten Elektrode besonders vorteilhaft ist:
Bevorzugt weist die zweite Elektrode ein metallisches oder graphitisches Stromzuführungselement, ein metallfreies Stromverteilungselement oder Stromverteilungsstruktur und eine kontaktbildende Struktur auf, welche derart angeordnet sind, dass beim an dem Unterdruck-Halteelement angeordneten Werkstück die Halteseite des Werkstücks an der kontaktbildenden Struktur anliegt und dass die kontaktbildende Struktur über das metallfreie Stromverteilungselement elektrisch leitend mit dem metallischen Stromzuführungselement verbunden ist.

Die Verwendung eines zwischen Stromzuführungselement und kontaktbildender Struktur zwischengeschalteten, metallfreien Stromverteilungselement weist den Vorteil auf, dass ein Eintrag prozessschädlicher metallischer Verunreinigungen deutlich reduziert werden kann. In der typischen Ausführungsform besteht der verwendete Elektrolyt aus korrosiven Medien, insbesondere Säuren, typischerweise Flusssäure, welche metallische Strukturen angreifen, insbesondere auch deren Dämpfe oberhalb des Ätzbades. Diese hierdurch verursachte Korrosion kann zur Verunreinigung des Ätzbades führen welche durch oben beschrieben Aufbau vermieden werden kann.

Das metallfreie Stromverteilungselement ist daher bevorzugt derart ausgebildet, dass das metallfreie Stromverteilungselement zumindest 80 %, insbesondere zumindest 95 % der dem Stromverteilungselement zugeordneten Fläche der kontaktbildenden Struktur elektrisch leitend bedeckt. Insbesondere weist die den elektrischen Kontakt zwischen Stromverteilungselement und kontaktbildender Struktur ausbildende Fläche zumindest eine Größe von zumindest 100 cm², insbesondere zumindest 200 cm², bevorzugt zumindest 250 cm² auf.

Die kontaktbildende Struktur wiederum kann darauf optimiert sein, einen homogenen und großflächigen elektrisch leitenden Kontakt an der Halteseite des Werkstücks auszubilden. Insbesondere ist die kontaktbildende Struktur bevorzugt gemäß einer der nachfolgend genannten vorteilhaften Ausführungsformen ausgebildet: als starre Platte, als weiches leitfähiges Gewebe, als bevorzugt regelmäßig angeordnetes Array von lokal kontaktierenden Kontaktelementen, als federnd an dem Unterdruck-Halteelement gelagertes Element und/oder mit einer strukturierten Kontaktseite zur Anlage an die Halteseite des Werkstücks.

Insbesondere eine bevorzugte Ausführungsform mit einer strukturiert ausgebildeten dem Werkstück zugewandten Seite der kontaktbildenden Struktur hat sich als vorteilhaft erwiesen, bevorzugt eine Pin-Struktur, Pyramidenspitzen, Halbkugelbesatz, aufgeraute z.B. sandgestrahlte Oberfläche, etc. Diese Strukturierung ist insbesondere geeignet, den elektrischen Kontakt bei Unebenheiten der Rückseite des Werkstücks, beispielsweise hervorgerufen durch Partikel, zu verbessern.

Ein robuster Aufbau ergibt sich in einer vorteilhaften Ausgestaltung, in welcher zumindest kontaktbildende Struktur und Stromverteilelement einstückig, bevorzugt monolithisch ausgebildet sind. Insbesondere die Verwendung einer Platte, bevorzugt einer Graphitplatte, als kontaktbildende Struktur und Stromverteilelement ist vorteilhaft.

Vorteilhafterweise weist die kontaktbildende Struktur Unterdruck-Verteilkanäle auf, die einerseits mit einem Unterdruckmittel verbindbar und andererseits zumindest eine Öffnung, bevorzugt eine Mehrzahl von Öffnungen an der dem Werkstück zugewandten Seite aufweisen.

Wie zuvor erwähnt, erfolgt das einseitige Ätzen mittels des erfindungsgemäßen Verfahrens und der erfindungsgemäßen Vorrichtung bevorzugt, indem im Wesentlichen nur die zu ätzende Seite der Halbleiterschicht mit Elektrolyt benetzt wird. Insbesondere erfolgt eine Kontaktierung des Werkstücks mittels der zweiten Elektrode bevorzugt derart, dass kein Elektrolyt in die Kontaktfläche zwischen zweiter Elektrode und Werkstück eindringt. Es erfolgt somit bevorzugt eine trockene Kontaktierung des Werkstücks mittels der zweiten Elektrode.

Das Unterdruck-Halteelement weist daher bevorzugt zumindest ein Dichtmittel auf, um bei an dem Unterdruck-Halteelement angeordnetem Werkstück ein Eindringen von Elektrolyt in die Kontaktfläche zwischen zweiter Elektrode und Werkstück zu verhindern. Das Dichtmittel ist daher bevorzugt derart ausgebildet, dass bei an dem Unterdruck-Halteelement angeordnetem Werkstück das Dichtmittel an dem Werkstück anliegt und die Kontaktfläche umschließt, bevorzugt vollständig umschließt. Das Dichtmittel ist bevorzugt umlaufend um eine Kontaktfläche der zweiten Elektrode zum Kontaktieren des Bergstücks ausgebildet.

Das Dichtmittel kann als an sich bekannte Dichtung, insbesondere als Dichtring ausgebildet sein. Solche Dichtringe weisen jedoch den Nachteil auf, dass hohe Anforderungen an das Material gestellt werden, die Dichtringe daher einem Verschleiß unterliegen und/oder hohe Materialkosten verursachen.

In einer vorteilhaften Ausführungsform weist das Unterdruck-Halteelement eine Sperrgas-Vorrichtung auf. Die Sperrgas-Vorrichtung ist ausgebildet, mittels Sperrgas ein Eindringen von Elektrolyt in die Kontaktfläche zwischen zweiter Elektrode und Werkstück zu verhindern oder zumindest das Risiko eines solchen Eindringens zu verringern. In dieser vorteilhaften Ausführungsform stellt die Sperrgas-Vorrichtung somit ein Dichtmittel dar.

Bei dem erfindungsgemäßen Verfahren erfolgt somit bevorzugt zumindest während des Ätzvorgangs das Spülen eines Randbereiches der dem Werkstück zugewandten Seite der zweiten Elektrode mit Sperrgas insbesondere bevorzugt eines umlaufenden Randbereiches, um einen Kontakt von Elektrolyt mit der zweiten Elektrode zu vermeiden oder zumindest dessen Risiko zu verringern. Als Sperrgas kann Umgebungsluft verwendet werden. Ebenso liegt die Verwendung von Inertgasen und/oder Edelgasen, insbesondere Stickstoff und/oder Argon im Rahmen der Erfindung.

Die Sperrgas-Vorrichtung weist bevorzugt einen Sperrgas-Verteilerkanal zum Verteilen des Sperrgases ausgehend von einem Sperrgas-Zufuhranschluss auf einer Mehrzahl von Sperrgas-Ausgabeöffnungen auf. Die Sperrgas-Ausgabeöffnungen sind bevorzugt um den Rand der zweiten Elektrode an der dem Werkstück zugewandten Seite verteilt. Ebenso liegt es im Rahmen der Erfindung, dass die Sperrgas-Vorrichtung Verteilerkanäle für das Sperrgas aufweist.

Eine elektrisch hochwertige und homogene Kontaktierung zwischen zweiter Elektrode und Werkstück ist zum Erzielen eines homogenen Ätzergebnisses hochrelevant. Vorteilhafterweise weist die erfindungsgemäße Vorrichtung daher eine Spülgas-Vorrichtung zum Freispülen der Kontaktfläche zwischen Werkstück und zweiter Elektrode vor und/oder während des Ansaugvorgangs und/oder des Ätzvorgangs auf. Die Spülgas-Vorrichtung ermöglicht somit vor Ansaugen des Werkstücks ein Freiblasen der Kontaktfläche der zweiten Elektrode. Ebenso kann nach Ansaugen des Werkstücks, insbesondere während des Ätzvorgangs ein gegebenenfalls unvorteilhafter Kontakt korrigiert werden, indem bevorzugt mittels eines Spülgas-Stoßes kurzzeitig Spülgas zumindest in Teilbereichen zwischen Werkstück und zweiter Elektrode eingeblasen wird. Aufgrund der Ausbildung des Halteelementes als Unterdruck-Halteelement wird das Spülgas durch die Mittel zum Erzeugen des Unterdrucks wieder abgesaugt. Bevorzugt weist das Unterdruck-Haltelement an der dem Werkstück zugewandten Seite zumindest eine, bevorzugt eine Mehrzahl von Spülgasaustrittsöffnungen auf, welche mit einem Spülgas-Zufuhreinlass fluidleitend verbunden sind, um Spülgas über den Spülgas-Zufuhreinlass zwischen Werkstück und Unterdruck-Halteelement zuzuführen.

Das Spülen erfolgt somit bevorzugt durch Zuführen von Spülgas mittels des Spülgasvorrichtung, insbesondere über die Spülgasaustrittsöffnungen. In einer vorteilhaften Ausgestaltung des erfindungsgemäßen Verfahrens wird zum Spülen Spülgas sowohl über die Spülgasaustrittsöffnungen, als auch über die zuvor beschriebene Sperrgas-Vorrichtung zugeführt.

Als Spülgas kann Umgebungsluft verwendet werden. Ebenso liegt die Verwendung von Inertgasen und/oder Edelgasen, insbesondere Stickstoff und/oder Argon im Rahmen der Erfindung.

Mittels des erfindungsgemäßen Verfahrens und der erfindungsgemäßen Vorrichtung kann insbesondere in vorteilhafter Weise ein Porosifizieren der Halbleiterschicht an der Ätzseite erfolgen, insbesondere wie in DE 10 2013 219 886 A1 beschrieben.

Die Erfindungsgemäße Vorrichtung weist bevorzugt eine Mehrzahl von Unterdruck-Halteelementen auf, welche gleichzeitig, bevorzugt in einem vorgegebenen, gleichbleibenden Abstand, Entlang einer Transportrichtung bewegt werden, um den Durchsatz zu erhöhen.

Weitere vorteilhafte Merkmale und Ausführungsformen werden im Folgenden anhand von Ausführungsbeispielen und den Figuren beschrieben. Dabei zeigt:
- Figur 1: ein erstes Ausführungsbeispiel einer erfindungsgemäßen Vorrichtung,
- Figur 2: eine Draufsicht von unten auf ein Unterdruck-Halteelement der Vorrichtung;
- Figur 3: einen Querschnitt durch das Unterdruck-Halteelement;
- Figur 4: ein zweites Ausführungsbeispiel mit seitlicher Erweiterung des Unterdruck-Halteelements um eine Sperrgas-Vorrichtung;
- Figur 5: einen Querschnitt durch das Unterdruck-Haltelement gemäß Figur 4;
- Figur 6: ein Ausführungsbeispiel eines Unterdruck-Halteelements, in dem die Funktionen der kontaktbildenden Struktur, des Stromverteilungselements, Teile des Stromzuführungselements sowie des Unterdruck-Haltelements in einem monolithischen Aufbau vereint sind;
- Figur 7: ein Ausführungsbeispiel eines Unterdruck-Halteelements mit Spülgasausstrittsöffnungen, Unterdruck-Verteilkanälen und Sperrgasvorrichtung in Draufsicht von unten und
- Figur 8: ein alternatives Ausführungsbeispiel eines Unterdruck-Halteelementes mit einem Dichtring in Draufsicht von unten.

In den Figuren sind schematische, nicht maßstabsgetreue Darstellungen gezeigt.

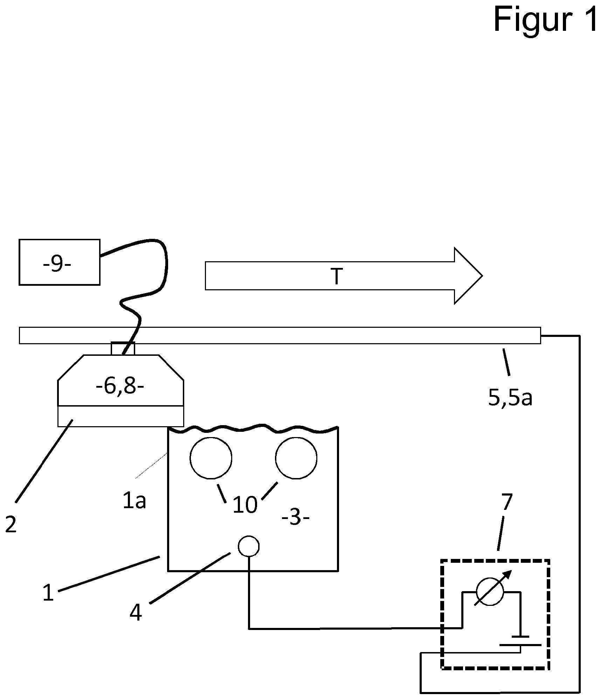

In Figur 1 ist ein Ausführungsbeispiel einer Vorrichtung zum einseitigen Ätzen einer Halbleiterschicht eines Werkstücks gezeigt. Die Vorrichtung weist ein Ätzbecken 1 auf und dient zum einseitigen Ätzen eines als Siliziumwafer ausgebildeten Werkstücks 2. Das Ätzbecken 1 ist mit Elektrolyt 3 gefüllt. In dem Ätzbecken ist als Kathode eine erste Elektrode 4 angeordnet. Oberhalb des Ätzbeckens 1 befindet sich ein Transportsystem 5. Dieses umfasst eine Transportschiene 5a mit integriertem Förderband sowie ein linear mittels des Förderbands entlang der Transportschiene 5a in Transportrichtung T verschiebbares Unterdruck-Halteelement 6.

Die Vorrichtung weist weiterhin eine Konstantstromquelle 7 auf, welche einerseits mit der ersten Elektrode 4 und andererseits mit einer Kontaktschiene, welche in die Führungsschiene 5a des Transportsystems integriert ist, elektrisch leitend verbunden ist.

Das Unterdruck-Halteelement 6 weist einen Schleifkontakt auf, welcher derart angeordnet ist, dass ein elektrischer Kontakt des Schleifkontakts zur Kontaktschiene der Transportschiene 5a besteht, auch während das Unterdruck-Halteelement 6 in Transportrichtung T bewegt wird.

Das Unterdruck-Halteelement 6 weist weiterhin eine als Anode ausgebildete zweite Elektrode auf. Diese ist innerhalb eines Gehäuses des Unterdruck-Halteelementes 6 derart angeordnet, dass bei an dem Unterdruck-Halteelement 6 angeordnetem Werkstück 2 dieses mit der (in der Figur obenliegenden) Halteseite des Werkstücks 2 flächig in elektrisch leitendem Kontakt steht.

Mittels der Konstantstromquelle 7 kann somit ein Ätzstrom zwischen erster Elektrode 4 und zweiter Elektrode 8 ausgebildet werden, um das Werkstück 2 an der untenliegenden, dem Elektrolyt 3 zugewandten Seite zu ätzen, vorliegend um eine Porosifizierung an der Ätzseite zu erzielen.

Die als Transportsystem 5 ausgebildete Transportvorrichtung ist somit zum Transport des Werkstücks 2 relativ zu dem Ätzbecken 1 derart ausgebildet, dass nur die zu ätzende (in der Figur untenliegende) Ätzseite des Werkstücks, welches vorliegend identisch mit der Halbleiterschicht ist, durch den Elektrolyten 3 benetzbar ist.

Die Vorrichtung ist dabei derart ausgebildet, dass während des Ätzvorgangs das Werkstück 2 ausschließlich mittels des Unterdruck-Halteelements 2 gehalten wird. Hierzu wird mit einem als Vakuumpumpe ausgebildeten Unterdruckmittel 9 ein Unterdruck von 1000 Pa erzeugt. Das Unterdruckmittel 9 ist über einen flexiblen Schlauch mit dem Unterdruck-Halteelement 6 verbunden, sodass mittels des Unterdrucks das Werkstück 2 durch das Unterdruck-Halteelement 6 gehalten und an die zweite Elektrode 8 angedrückt wird. Die Vorrichtung weist weiterhin ein Sicherheits-Transportsystem 10 auf, welches vorliegend durch mehrere sich gleichläufig drehende Walzen ausgebildet ist. Aus Gründen der Übersichtlichkeit sind lediglich zwei Walzen dargestellt. In einer alternativen Ausführungsform weist das Sicherheits-Transportsystem Ketten zum Fördern eines abgefallenen Werkstücks oder Bruchstücken hiervon auf.

Die Walzen sind mit geringem Abstand (vorliegend 5 mm) unterhalb der Oberfläche des Elektrolyten 3 angeordnet, sodass während des Ätzvorgangs kein Kontakt zwischen Werkstück 2 und den Walzen des Sicherheits-Transportsystems 10 besteht. Sollte sich das Werkstück 2 aufgrund eines Fehlers von dem Unterdruck-Halteelement 6 lösen, insbesondere zerbrechen, so wird das Werkstück 2 oder dessen Bruchstücke, sofern sie eine ausreichende Größe und Form aufweisen, mittels der Walzen 6 in Transportrichtung zum Rand des Ätzbeckens 1 geführt und dort über den Rand geschoben und somit ausgegeben.

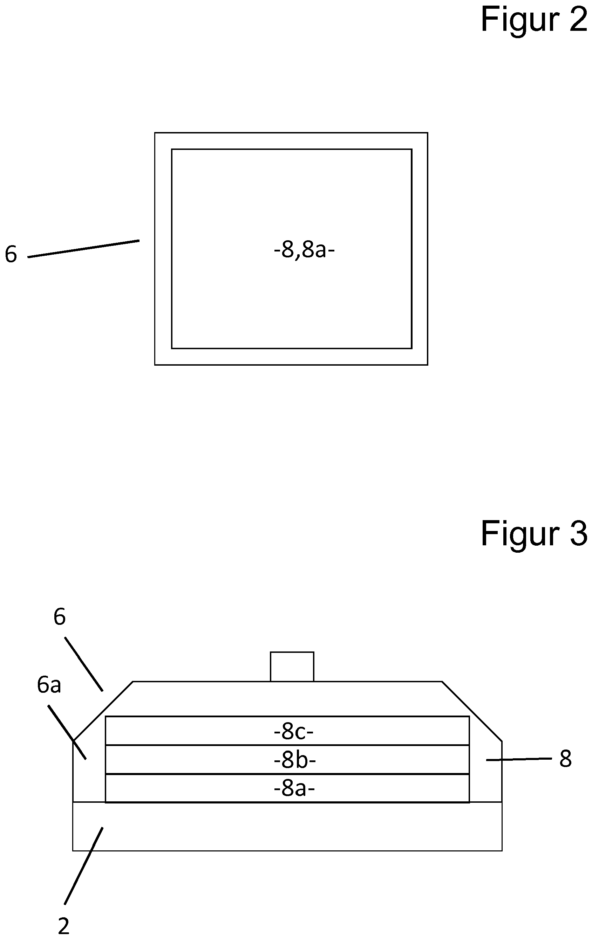

In Figur 2 ist eine Draufsicht von unten auf das Unterdruck-Halteelement 6 dargestellt. Das Unterdruck-Halteelement 6 weist eine Art Vakuum-Glocke auf, welche nach unten geöffnet ist. In Figur 2 ist in der Draufsicht von unten daher der äußere, umlaufende Rand des Unterdruck-Halteelementes 6 ersichtlich. Dieser liegt am Rand der Halteseite des Werkstücks 2 auf. Dieses nach Art einer Vakuum-Glocke ausgebildete Element des Unterdruck-Halteelementes ist aus einem elektrisch nichtleitenden Material, vorliegend aus Kunststoff, beispielsweise PE, PP, PEEK, PTFE oder PFA, ausgebildet und weist an der dem Werkstück 2 zugewandten Seite eine umlaufende Randdichtung auf, vorliegend aus Teflon, alternativ aus Kalrez. Hierdurch kann ein luftdichter Abschluss zwischen Unterdruck-Halteelement 6 und dem Rand des Werkstücks 2 an der Halteseite ausgebildet werden. Innerhalb des nach Art einer Vakuum-Glocke ausgebildeten Elementes des Unterdruck-Halteelementes ist die zweite Elektrode 8 angeordnet, deren Aufbau in Figur 3 näher beschrieben wird. Bei Draufsicht von unten ist ein kontaktbildendes Element 8a, welches vorliegend als plane Platte mit einer Dicke von 10 mm aus Graphit ausgebildet ist, ersichtlich.

Vorliegend weist das kontaktbildende Element 8a eine Fläche von 13 x 13 cm² auf. Das Werkstück weist sowohl an der zu ätzenden Seite als auch an der Halteseite eine Fläche von 15,7 x 15,7 cm² auf. Bei zentriertem Anordnen des Werkstücks 2 an dem Unterdruck-Halteelement 6 ergibt sich somit ein umlaufender Rand von 1,35 cm zwischen dem Rand des kontaktbildenden Elementes 8a und dem Rand der Halteseite des Werkstücks 2. Hierdurch werden in besonders effizienter Weise Leckströme vermieden, welche zu einem inhomogenen Ätzvorgang führen können.

In Figur 3 ist ein Querschnitt durch das Unterdruck-Halteelement 6 dargestellt. Der Querschnitt erfolgt parallel zur Zeichenebene gemäß Figur 1. Das Unterdruck-Halteelement 6 weist ein äußeres Gehäuse auf, welches - wie zuvor beschrieben - nach Art einer Vakuum-Glocke 6a ausgebildet ist. Die Vakuum-Glocke 6a weist an der oberen Seite eine Öffnung zum Verbinden mit dem Unterdruckmittel 9 auf. Innerhalb der Vakuum-Glocke 6a ist die zweite Elektrode 8 ortsfest an der Vakuum-Glocke 6a angeordnet. Die zweite Elektrode 8 weist vorliegend das zuvor beschriebene kontaktbildende Element als kontaktbildende Struktur 8a, ein Stromverteilungselement 8b und ein Stromzuführungselement 8c auf. Das Stromzuführungselement ist aus Kupfer ausgebildet und weist ein Kabel zum Verbinden mit dem Schleifkontakt auf, welcher die Stromzuführungsschiene an der Transportschiene 5a kontaktiert. Alternativ ist das Stromzuführungselement aus Platin oder Graphit ausgebildet. Weiterhin weist das Stromzuführungselement 8c eine Kupferplatte auf, welche die vorgenannte Fläche der kontaktbildenden Struktur 8a besitzt. Zwischen der kontaktbildenden Struktur 8a und der Kupferplatte des Stromzuführungselementes 8c ist ein als Grafitplatte mit einer Dicke von 10 mm ausgebildetes Stromverteilungselement 8b angeordnet, welches ebenfalls die Fläche der kontaktbildenden Struktur 8a besitzt. Durch diesen dreischichtigen Aufbau ist somit eine homogene Stromzufuhr zu der kontaktbildenden Struktur 8a gewährleistet. Darüber hinaus ist durch das metallfreie Stromverteilungselement 8b gewährleistet, dass das Verteilelement 8b von korrosiven Dämpfen welche vom Ätzbereich emittiert werden geschützt ist.

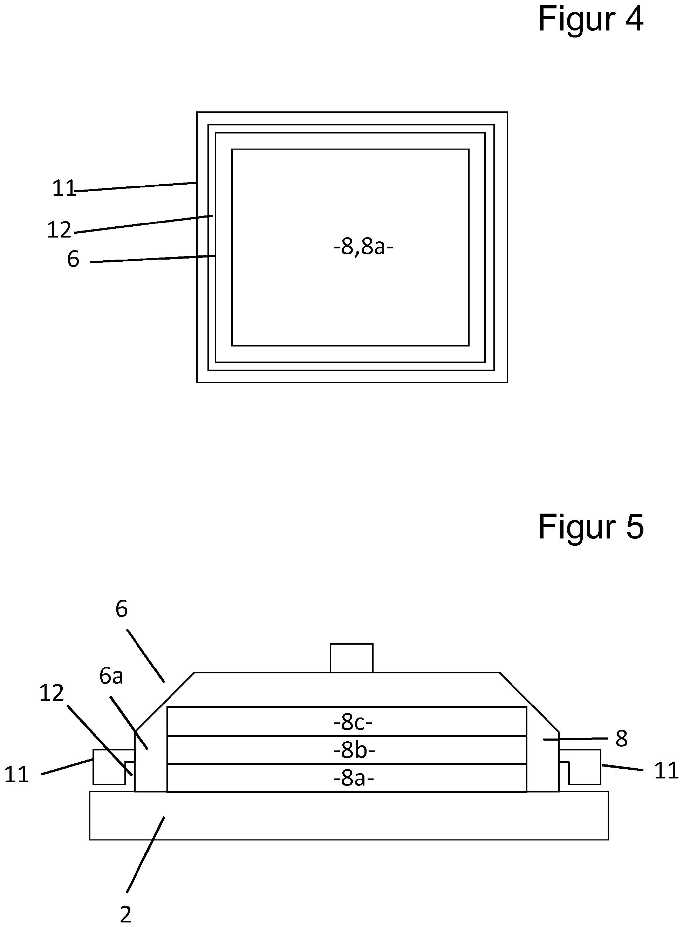

In den Figuren 4 und 5 ist ein zweites Ausführungsbeispiel einer erfindungsgemäßen Vorrichtung gezeigt, welches eine seitliche Erweiterung des Unterdruck-Halteelementes um eine Sperrgas-Vorrichtung aufweist. Die Vorrichtung ist grundsätzlich analog zu dem ersten Ausführungsbeispiel aufgebaut. Im Folgenden werden daher zur Vermeidung von Wiederholungen lediglich die wesentlichen Unterschiede erläutert:
Das Unterdruck-Halteelement 8 weist zusätzlich eine Sperrgas-Vorrichtung 11 auf, welche den Rand des Unterdruck-Halteelementes 6 umlaufend ausgebildet ist. Insbesondere ist in der Sperrgas-Vorrichtung 11 ein Sperrgas-Verteilkanal 12 ausgebildet, welcher einen Rand des Unterdruck-Halteelementes 6, welcher das Werkstück 2 berührt, umläuft. Die umlaufende Ausbildung ist in der Draufsicht von unten auf das Unterdruck-Halteelement 6 gemäß Figur 4 gezeigt. Figur 4 zeigt somit eine korrespondierende Ansicht zu Figur 2.

Entsprechend zeigt Figur 5 einen Schnitt durch das Unterdruck-Halteelement 6 gemäß dem zweiten Ausführungsbeispiel. Die Ansicht gemäß Figur 5 korrespondiert somit zu der Darstellung gemäß Figur 3.

Das Werkstück 6 weist am äußeren Rand die Sperrgas-Vorrichtung 11 auf mit dem Sperrgas-Verteilkanal 12. Innerhalb des umlaufenden Sperrgas-Verteilkanals 12 ist das Unterdruck-Halteelement 6 in Kontakt mit dem Werkstück 2, um einen Unterdruck auszubilden. Der Sperrgas-Verteilkanal 12 ist somit die Vakuum-Glocke 6a des Unterdruck-Halteelementes 6 umlaufend ausgebildet. Wie in Figur 5 ersichtlich, berührt die Sperrgas-Vorrichtung 11 das Werkstück 2 nicht, sondern ist zu diesem beabstandet, um einen Sperrgas-Austrittkanal zu bilden. Wird nun Sperrgas, vorliegend Umgebungsluft (ebenso ist die Verwendung von Inertgas wie beispielsweise Stickstoff oder Argon möglich) in den Sperrgas-Verteilkanal geleitet so entweicht das Sperrgas seitlich nach außen. Hierdurch wird ein Eindringen von Elektrolyt vermieden oder zumindest erheblich verringert und somit das Risiko, dass Elektrolyt in die Kontaktfläche zwischen kontaktbildender Struktur 8a und Werkstück 2 eindringt, ebenfalls erheblich verringert.

Das Unterdruck-Halteelement 6 weist daher am oberen Rand zusätzlich einen Anschluss zum Zuführen des Sperrgases auf, welcher mit dem Sperrgas-Verteilkanal 12 fluidleitend verbunden ist. Die Vorrichtung weist eine Sperrgas-Quelle auf, insbesondere ein Gebläse, welche fluidleitend mit dem Sperrgas-Zuführanschluss verbunden ist.

Der Gasfluss des Sperrgases beträgt bevorzugt zumindest 1 cm³/Minute. Insbesondere liegt der Gasfluss bevorzugt im Bereich 1 cm³/min bis 100 l/min.

Im Sperrgas-Verteilkanal wird bevorzugt mittels des Sperrgases ein Überdruck im Bereich 1 Pa bis 5000 Pa erzeugt.

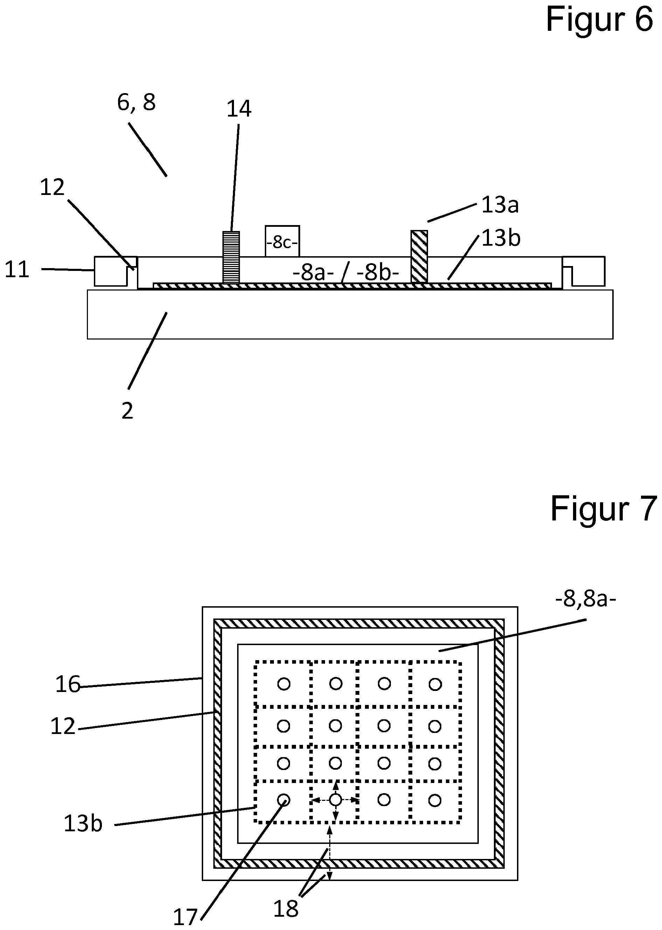

In Figur 6 ist ein weiteres Ausführungsbeispiel eines Unterdruck-Halteelementes 6 dargestellt.

In diesem Ausführungsbeispiel ist die Funktion der kontaktbildenden Struktur, des Stromverteilungselementes sowie Teile des Stromzuführungselementes und des Unterdruck-Halteelementes in einem monolithischen Aufbau vereint:
Mittels einer Graphit-Platte mit einer Dicke von 1 cm sind die kontaktbildende Struktur 8a und das Stromverteilungselement 8b ausgebildet: Die Graphitplatte weist einen Unterdruck-Anschluss 13a auf, welcher fluidleitend mit Unterdruck-Verteilkanälen 13b an der dem Werkstück 2 zugewandten Seite des Unterdruck-Halteelementes 6 ausgebildet sind. Der Unterdruck-Anschluss 13a ist fluidleitend mit dem Unterdruckmittel 9 verbunden.

An der dem Werkstück 2 abgewandten Seite der Graphitplatte ist das Stromführungselement 8c angeordnet. Dieses weist eine kleinere Fläche als das Stromverteilelement 8b auf. Dies kann derart gewählt werden, da die Graphitplatte eine ausreichende Dicke und somit ausreichende elektrische Querleiteigenschaften aufweist, um einen homogenen Ätzstrom zu erzielen.

Die Unterdruck-Verteilkanäle 13b bilden lediglich einen kleinen Teil der dem Werkstück 2 zugewandten Fläche der Graphitplatte aus: Etwa 10% der Kontaktfläche ist mit Unterdruck-Verteilkanälen strukturiert ausgebildet. Die verbleibende Kontaktfläche dient zum flächigen Kontaktieren des Werkstücks 2.

An Rand der Graphitplatte ist eine Sperrgas-Vorrichtung 11 mit Sperrgas-Verteilkanal 12 ausgebildet, welche analog zu dem zweiten Ausführungsbeispiel ausgebildet und angeschlossen ist.

Das Unterdruck-Halteelement 6 gemäß Figur 6 wird ebenfalls in einer Vorrichtung wie zu Figur 1 und dem ersten Ausführungsbeispiel beschrieben, verwendet. Wie auch bei dem zweiten Ausführungsbeispiel weist die Vorrichtung zusätzlich ein Gebläse zum Zuführen von Sperrgas auf.

Das Unterdruck-Halteelement 6 weist weiterhin eine Spülgas-Vorrichtung 14 auf. Diese ist fluidleitend mit dem Unterdruck-Anschluss 13a, insbesondere den Unterdruck-Verteilkanälen 13b verbunden.

In Figur 7 ist ein weiteres Ausführungsbeispiel eines Unterdruck-Halteelementes in Draufsicht von unten dargestellt: Der Aufbau entspricht dem Aufbau gemäß Figur 4, die Kontaktfläche der kontaktbildenden Struktur 8a weist jedoch eine Mehrzahl von Spülgasaustrittsöffnungen 17 auf, welche mit einem Spülgas-Zufuhreinlass fluidleitend verbunden sind. Weiterhin weist die kontaktbildende Struktur Unterdruck-Verteilkanäle 13b auf, welche mit dem Unterdruckmittel 9 fluidleitend verbunden sind, um das Werkstück 2 mittels Unterdruck an das Unterdruck-Halteelement 6 anzudrücken und zu halten. Das Sperrgas wird entsprechend der Gasflussrichtung 18 durch den Spalt zwischen Sperrgasvorrichtung 11 und Werkstück 2 nach außen sowie in die Unterdruck-Verteilkanäle 13b verteilt.

In einem weiteren vorteilhaften Ausführungsbeispiel ist das Unterdruck-Halteelement gemäß Figur 6 analog der Ansicht und Beschreibung zu Figur 7 ausgebildet und die Spülgas-Vorrichtung 14 ist mit den Spülgasaustrittsöffnungen 17 fluidleitend verbunden: Bei bereits an dem Unterdruck-Halteelement 6 angeordnetem Werkstück 2 erfolgt ein Reinigen der Kontaktfläche wie folgt: Während des Ansaugens wird ein Spülgas (vorliegend Luft, ebenso liegt ein Inertgas wie z.B. Stickstoff oder Argon im Rahmen der Erfindung) über die Spülgas-Vorrichtung 14 durch die Spülgasaustrittsöffnungen 17 sowie bevorzugt durch den Sperrgaseinlass 17 der Kontaktfläche zwischen 8a und Werkstück 2 zugeleitet. Die Zufuhr ist derart dimensioniert, dass das Spülgas durch das Unterdruckmittel 9 über die Unterdruckverteilkanäle 13b abgesaugt wird und darüber hinaus ein Unterdruck aufrechterhalten wird, so dass das Werkstück 2 an dem Unterdruck-Halteelement 6 angeordnet bleibt. Hierbei strömt das Spülgas entlang der Saugseite gemäß den Pfeilen (18) definierten Richtungen. Auf diese Weise können Fremdpartikel über den Unterdruck-Anschluss 13a abgesaugt werden.

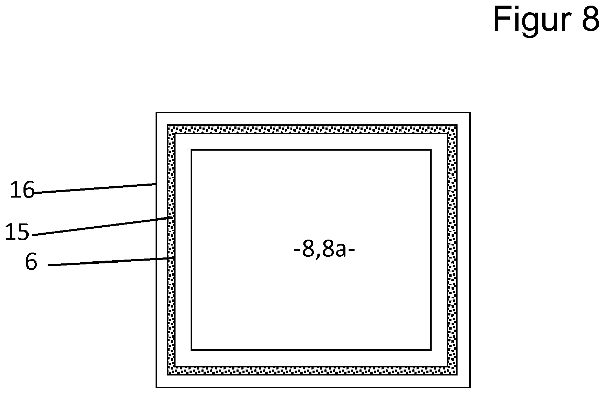

In Figur 8 ist ein weiteres Ausführungsbeispiel eines Unterdruck-Haltemittels dargestellt, welches als Dichtmittel einen Dichtring aufweist: In Figur 8 ist eine Alternative zu dem in den Figuren 4 und 5 dargestellten Unterdruck-Halteelement 6 gezeigt. Dieses Unterdruck-Halteelement weist als Dichtmittel nicht eine Sperrgas-Vorrichtung wie in den Figuren 4 und 5 gezeigt auf, sondern einen Dichtring 15, welcher den Bereich des Unterdruck-Halteelementes 6, welcher das Werkstück 2 berührt, umlaufend ausgebildet ist und durch einen Einbaurahmen 16 für den Dichtring gehalten wird.

### Bezugszeichenliste

- 1: Ätzbecken
- 2: Werkstück
- 3: Elektrolyt
- 4: erste Elektrode
- 5: Transportsystem
- 5a: Transportschiene
- 6: Unterdruck-Halteelement
- 6a: Vakuum-Glocke
- 7: Konstantstromquelle
- 8: zweite Elektrode
- 8a: kontaktbildende Struktur
- 8b: Stromverteilungselement
- 8c: Stromzuführungselement
- 9: Unterdruckmittel
- 10: Sicherheits-Transportsystem
- 11: Sperrgas-Vorrichtung
- 12: Sperrgas-Verteilkanal
- 13a: Unterdruck-Anschluss
- 13b: Unterdruck-Verteilkanäle
- 14: Spülgas-Vorrichtung
- 15: Dichtungselement
- 16: Einbaurahmen für Dichtungselement
- 17: Spülgasaustrittsöffnung
- 18: Flussrichtung des Sperrgases

## Patentansprüche

1. Vorrichtung zum einseitigen Ätzen einer Halbleiterschicht eines Werkstücks (2), mit zumindest einem Ätzbecken (1) zur Aufnahme eines Elektrolyten (3),
- einer ersten Elektrode (4), welche zur elektrischen Kontaktierung des sich bei Benutzung in dem Ätzbecken (1) befindenden Elektrolyten angeordnet ist,
- zumindest einer zweiten Elektrode (8), welche zur mittelbaren oder unmittelbaren elektrischen Kontaktierung der Halbleiterschicht angeordnet ist,
- zumindest einer elektrischen Stromquelle (7), welche mit der ersten und der zweiten Elektrode zum Erzeugen eines Ätzstroms elektrisch leitend verbunden ist und
- zumindest einer Transportvorrichtung zum Transport des Werkstücks relativ zu dem Ätzbecken (1), derart, dass eine zu ätzende Ätzseite der Halbleiterschicht durch den sich bei Benutzung in dem Ätzbecken (1) befindenden Elektrolyten benetzbar ist,
**dadurch gekennzeichnet,**
**dass** die Transportvorrichtung ein Unterdruck-Halteelement (6) für das Werkstück (2) aufweist, das Unterdruck-Halteelement (6) zum Anordnen des Werkstücks an einer der Ätzseite gegenüberliegenden Halteseite des Werkstücks mittels Unterdruck ausgebildet ist und dass die zweite Elektrode (8) derart an dem Unterdruck-Halteelement (6) angeordnet ist, dass bei an dem Unterdruck-Halteelement (6) angeordnetem Werkstück (2) eine Kontaktierung der Halteseite des Werkstücks mittels der zweiten Elektrode erfolgt.

2. Vorrichtung nach Anspruch 1,
**dadurch gekennzeichnet,**
**dass** die Vorrichtung ausgebildet ist, während des Ätzvorgangs das Werkstück (2) ausschließlich mittels des Unterdruck-Halteelementes zu halten.

3. Vorrichtung nach einem der vorangegangenen Ansprüche,
**dadurch gekennzeichnet,**
**dass** die Vorrichtung ein Sicherheits-Transportsystem aufweist, welches zumindest ein Auffangelement umfasst, insbesondere, dass das Sicherheits-Transportsystem ausgebildet ist, das Auffangelement während des Ätzvorgangs im Elektrolyten synchron zu dem Unterdruck-Halteelement zu bewegen.

4. Vorrichtung nach Anspruch 3,
**dadurch gekennzeichnet,**
**dass** Transportsystem (5) und Sicherheits-Transportsystem derart ausgebildet sind, dass während des Ätzvorgangs kein Kontakt zwischen Werkstück (2) und Auffangelement besteht, insbesondere bei unbeschädigtem Werkstück (2).

5. Vorrichtung nach einem der vorangegangenen Ansprüche,
**dadurch gekennzeichnet,**
**dass** die Vorrichtung ein Unterdruckmittel (9) aufweist, welche mit dem Unterdruck-Halteelement (6) zusammenwirkend ausgebildet ist, um einen Anpressdruck des Werkstücks an die zweite Elektrode (8) im Bereich 10 Pa bis 500 mBar, bevorzugt im Bereich 200 Pa bis 2000 Pa zu erzeugen und/oder
**dass** die zweite Elektrode (8) als Flächenelektrode ausgebildet ist, insbesondere, dass die zweite Elektrode (8) zur Bedeckung einer Fläche von zumindest 100 cm², insbesondere zumindest 150 cm², weiter bevorzugt zumindest 200 cm² der Halteseite des Werkstücks ausgebildet ist.

6. Vorrichtung nach einem der vorangegangenen Ansprüche,
**dadurch gekennzeichnet,**
**dass** die zweite Elektrode (8) ein metallisches Stromzuführungselement (8c), ein metallfreies Stromverteilungselement (8b) und eine kontaktbildende Struktur (8a) aufweist, welche derart angeordnet sind, dass bei an dem Unterdruck-Halteelement (6) angeordnetem Werkstück (2) die Halteseite des Werkstücks an der kontaktbildenden Struktur anliegt und dass die kontaktbildende Struktur (8a) über das metallfreie Stromverteilungselement (8b) elektrisch leitend mit dem metallischen Stromzuführungselement (8c) verbunden ist.

7. Vorrichtung nach Anspruch 6,
**dadurch gekennzeichnet,**
**dass** das metallfreie Stromverteilungselement (8b) zumindest 80% insbesondere zumindest 95% der dem Stromverteilungselement (8b) zugeordneten Fläche der kontaktbildenden Struktur elektrisch leitend bedeckt und/oder
**dass** die kontaktbildende Struktur (8a) ausgebildet ist als starre Platte, weiches Gewebe, Nadelkissen, federnd an dem Unterdruck-Halteelement (6) gelagertes Element und/oder mit einer strukturierten Kontaktseite ausgebildet ist und/oder
**dass** zumindest Stromverteilungselement (8b) und kontaktbildende Struktur (8a) einstückig, insbesondere monolithisch ausgebildet sind.

8. Vorrichtung nach einem der vorangegangenen Ansprüche,
**dadurch gekennzeichnet,**
**dass** das Unterdruck-Halteelement zumindest ein Dichtmittel aufweist, um bei an dem Unterdruck-Halteelement angeordnetem Werkstück das Risiko eines Eindringen von Elektrolyt in die Kontaktfläche zwischen zweiter Elektrode und Werkstück zu verringern.

9. Vorrichtung nach Anspruch 8,
**dadurch gekennzeichnet,**
**dass** das Dichtmittel eine Sperrgas-Vorrichtung (11) aufweist, welche ausgebildet ist, mittels eines Sperrgasflusses das Risiko eines Eindringen von Elektrolyt in die Kontaktfläche zwischen zweiter Elektrode (8) und Werkstück (2) zu verringern.

10. Vorrichtung nach einem der vorangegangenen Ansprüche,
**dadurch gekennzeichnet,**
**dass** die Vorrichtung eine Spülgas-Vorrichtung (14) zum Freispülen der Kontaktfläche zwischen Werkstück (2) und zweiter Elektrode (8) vor und/oder während des Ansaugvorgangs und/oder des Ätzvorgangs umfasst.

11. Verfahren zum einseitigen Ätzen einer Halbleiterschicht eines Werkstücks (2),
wobei die Halbleiterschicht an einer zu ätzenden Ätzseite mit einem Elektrolyt (3) Elektrolyt benetzt wird,
der Elektrolyt (3) mit einer ersten Elektrode (4) und das Werkstück (2) an einer dem Elektrolyt (3) abgewandten Seite mit einer zweiten Elektrode elektrisch kontaktiert wird und zwischen den Elektroden ein Ätzstrom ausgebildet wird,
**dadurch gekennzeichnet,**
**dass** während des Ätzvorgangs das Werkstück (2) ausschließlich an einer der Ätzseite gegenüberliegenden Halteseite mittels Unterdruck gehalten und an die zweite Elektrode (8) angedrückt wird.

12. Verfahren nach Anspruch 11,
**dadurch gekennzeichnet,**
**dass** das Werkstück (2) mittels Unterdruck mit einem Druck im Bereich 10 Pa bis 50.000 Pa, bevorzugt im Bereich 200 Pa bis 2000 Pa an die zweite Elektrode (8) angedrückt wird und/oder dass während des Ätzvorgangs die zweite Elektrode (8) die Halteseite des Werkstücks trocken kontaktiert.

13. Verfahren nach einem der Ansprüche 11 bis 12,
**dadurch gekennzeichnet,**
**dass** während des Ätzvorgangs die zweite Elektrode (8) eine Fläche von zumindest 80%, bevorzugt zumindest 95% der Halteseite des Werkstücks kontaktiert und/oder
**dass** die zweite Elektrode (8) die Halteseite des Werkstücks mit einem Randabstand im Bereich von 5 mm bis 20 mm zu dem Rand des Werkstücks kontaktiert, insbesondere mit einem umlaufenden Randabstand.

14. Verfahren nach einem der Ansprüche 11 bis 13,
**dadurch gekennzeichnet,**
**dass** an der Ätzseite durch den Ätzvorgang eine poröse Schicht erstellt wird, insbesondere eine Porosifizierung erfolgt und/oder dass die Werkstückoberkante unterhalb des Elektrolytspiegels transportiert wird..

15. Verfahren nach einem der Ansprüche 11 bis 14,
**dadurch gekennzeichnet,**
**dass** parallel zu der Ansaugung des Werkstücks (2) mit Unterdruck das Ätzmedium durch ein auf einen Rand des Werkstücks (2) auf der durch die zweite Elektrode kontaktierten Fläche aufgeprägtes Sperrgas von der kontaktbildenden Elektrode entfernt gehalten wird.

## Claims

1. Device for one-sided etching of a semiconductor layer of a workpiece (2) having at least one etching tank(1) for holding an electrolyte (3),
- a first electrode (4) which is arranged for electrically contacting the electrolyte that is located in the etching tank (1) during use,
- at least one second electrode (8) which is arranged for indirectly or directly electrically contacting the semiconductor layer,
- at least one electrical power source (7) which is in electrically conductive connection with the first and second electrodes in order to generate an etching current and
- at least one transport device for transporting the workpiece relative to the etching tank (1) in such a way that an etching side of the semiconductor layer that is to be etched is wettable by the electrolyte that is located in the etching tank (1) during use,
**characterised in that**
the transport device has a vacuum holding element (6) for the workpiece (2), the vacuum holding element (6) being configured for arrangement of the workpiece on a holding side of the workpiece, which holding side is located opposite the etching side, by means of a vacuum; and
the second electrode (8) is arranged on the vacuum holding element (6) in such a way that when the workpiece (2) is arranged on the vacuum holding element (6), the holding side of the workpiece is contacted by means of the second electrode.

2. Device according to claim 1,
**characterised in that**
the device is configured to hold the workpiece (2) solely by means of the vacuum holding element during the etching operation.

3. Device according to either one of the preceding claims, **characterised in that**
the device has a safety transport system which comprises at least one catching element, the safety transport system especially being configured to move the catching element in the electrolyte synchronously with the vacuum holding element during the etching operation.

4. Device according to claim 3,
**characterised in that**
the transport system (5) and the safety transport system are configured in such a way that during the etching operation there is no contact between the workpiece (2) and the catching element, especially in the case of an undamaged workpiece (2).

5. Device according to any one of the preceding claims,
**characterised in that**
the device has a vacuum means (9) which is configured to co-operate with the vacuum holding element (6) in order to generate a contact pressure of the workpiece against the second electrode (8) in the range of 10 Pa to 500 mbar, preferably in the range of 200 Pa to 2000 Pa; and/or
the second electrode (8) is configured as a planar electrode, the second electrode (8) especially being configured to cover a surface area of at least 100 cm², especially at least 150 cm², more preferably at least 200 cm², of the holding side of the workpiece.

6. Device according to any one of the preceding claims,
**characterised in that**
the second electrode (8) has a metallic current supply element (8c), a metal-free current distribution element (8b) and a contact-forming structure (8a), which are arranged in such a way that when the workpiece (2) is arranged on the vacuum holding element (6), the holding side of the workpiece is in contact with the contact-forming structure; and the contact-forming structure (8a) is in electrically conductive connection with the metallic current supply element (8c) via the metal-free current distribution element (8b).

7. Device according to claim 6,
**characterised in that**
the metal-free current distribution element (8b) electrically conductively covers at least 80 %, especially at least 95 %, of the surface area of the contact-forming structure that is associated with the current distribution element (8b); and/or
the contact-forming structure (8a) is configured as a rigid plate, a soft woven fabric, a pincushion, an element resiliently mounted on the vacuum holding element (6) and/or has a structured contact side; and/or
at least the current distribution element (8b) and the contact-forming structure (8a) are formed in one piece, especially monolithically.

8. Device according to any one of the preceding claims,
**characterised in that**
the vacuum holding element has at least one sealing means in order to reduce the risk of penetration of electrolyte into the contact surface between the second electrode and the workpiece when the workpiece is arranged on the vacuum holding element.

9. Device according to claim 8,
**characterised in that**
the sealing means has a barrier gas device (11) which is configured to reduce, by means of a flow of barrier gas, the risk of penetration of electrolyte into the contact surface between the second electrode (8) and the workpiece (2).

10. Device according to any one of the preceding claims,
**characterised in that**
the device comprises a flushing gas device (14) for flushing the contact surface between the workpiece (2) and the second electrode (8) before and/or during the suction procedure and/or the etching operation.

11. Method for one-sided etching of a semiconductor layer of a workpiece (2), wherein the semiconductor layer is wetted with an electrolyte (3) on an etching side that is to be etched, the electrolyte (3) is electrically contacted by a first electrode (4), and the workpiece (2) is electrically contacted on a side remote from the electrolyte (3) by a second electrode, and an etching current is generated between the electrodes,
**characterised in that**
during the etching operation the workpiece (2) is held and pressed against the second electrode (8) by means of a vacuum solely on a holding side which is located opposite the etching side.

12. Method according to claim 11,
**characterised in that**
the workpiece (2) is pressed against the second electrode (8) by means of a vacuum with a pressure in the range of 10 Pa to 50,000 Pa, preferably in the range of 200 Pa to 2000 Pa; and/or
during the etching operation the second electrode (8) makes dry contact with the holding side of the workpiece.

13. Method according to either one of claims 11 and 12,
**characterised in that**
during the etching operation the second electrode (8) contacts a surface area of at least 80 %, preferably at least 95 %, of the holding side of the workpiece; and/or
the second electrode (8) contacts the holding side of the workpiece at a distance in the range of 5 mm to 20 mm from the edge of the workpiece, especially at a distance from the peripheral edge.

14. Method according to any one of claims 11 to 13,
**characterised in that**
the etching operation results in the creation of a porous layer on the etching side, especially porosification takes place; and/or the upper edge of the workpiece is transported below the level of the electrolyte.

15. Method according to any one of claims 11 to 14,
**characterised in that**
in parallel with the workpiece (2) being subjected to suction by means of a vacuum, the etching medium is kept away from the contact-forming electrode by a barrier gas which is applied to an edge of the workpiece (2) on the surface contacted by the second electrode.

## Revendications

1. Dispositif pour la gravure unilatérale d'une couche de semi-conducteur d'une pièce (2), comprenant au moins un bassin de gravure (1) pour recevoir un électrolyte (3),
- une première électrode (4) qui est disposée pour le contact électrique de l'électrolyte qui se trouve dans le bassin de gravure (1) lors de l'utilisation,
- au moins une deuxième électrode (8) qui est disposée pour le contact électrique indirect ou direct de la couche de semi-conducteur,
- au moins une source de courant électrique (7) qui est reliée de manière électroconductrice aux première et deuxième électrodes pour produire un courant de gravure et
- au moins un dispositif de transport pour le transport de la pièce par rapport au bassin de gravure (1) de telle sorte qu'un côté de gravure à graver de la couche de semi-conducteur puisse être mouillé par l'électrolyte qui se trouve dans le bassin de gravure (2) lors de l'utilisation,
**caractérisé en ce que**
le dispositif de transport présente un élément de maintien à dépression (6) pour la pièce (2), l'élément de maintien à dépression (6) est formé pour la disposition de la pièce d'un côté de maintien de la pièce opposé au côté de gravure au moyen d'une dépression et
la deuxième électrode (8) est disposée sur l'élément de maintien à dépression (6) de telle sorte que lorsque la pièce (2) est disposée sur l'élément de maintien à dépression (6), un contact du côté de maintien de la pièce ait lieu au moyen de la deuxième électrode.

2. Dispositif selon la revendication 1,
**caractérisé en ce que**
le dispositif est formé pour maintenir la pièce (2) pendant l'opération de gravure uniquement au moyen de l'élément de maintien à dépression.

3. Dispositif selon l'une des revendications précédentes,
**caractérisé en ce que**
le dispositif présente un système de transport de sécurité qui comprend au moins un élément de réception, en particulier le système de transport de sécurité est formé pour déplacer l'élément de réception dans l'électrolyte de manière synchrone par rapport à l'élément de maintien à dépression (6) pendant l'opération de gravure.

4. Dispositif selon la revendication 3,
**caractérisé en ce que**
le système de transport (5) et le système de transport de sécurité sont formés de telle sorte qu'il n'y ait pas de contact entre la pièce (2) et l'élément de réception pendant l'opération de gravure, en particulier en présence d'une pièce (2) non endommagée.

5. Dispositif selon l'une des revendications précédentes,
**caractérisé en ce que**
le dispositif présente un moyen de dépression (9) qui est formé pour coopérer avec l'élément de maintien à dépression (6) afin de produire une pression d'application de pièce contre la deuxième électrode (8) dans la plage de 10 Pa à 500 mbar, de préférence dans la plage de 200 Pa à 2000 Pa et/ou
la deuxième électrode (8) est formée en tant qu'électrode plate, en particulier la deuxième électrode (8) est formée pour couvrir une surface d'au moins 100 cm², en particulier d'au moins 150 cm², de manière plus préférée d'au moins 200 cm² du côté de maintien de la pièce.

6. Dispositif selon l'une des revendications précédentes,
**caractérisé en ce que**
la deuxième électrode (8) présente un élément métallique d'alimentation en courant (8c), un élément sans métal de distribution de courant (8b) et une structure formant contact (8a) qui sont disposés de telle sorte que lorsqu'une pièce (2) est disposée sur l'élément de maintien à dépression (6), le côté de maintien de la pièce soit appliqué contre la structure formant contact et que la structure formant contact (8a) soit reliée de manière électroconductrice à l'élément métallique d'alimentation en courant (8c) par l'élément sans métal de distribution de courant (8b).

7. Dispositif selon la revendication 6,
**caractérisé en ce que**
l'élément sans métal de distribution de courant (8b) couvre de manière électroconductrice au moins 80 %, en particulier au moins 95 % de la surface de la structure formant contact associée à l'élément de distribution de courant (8b) et/ou
la structure formant contact (8a) est conformée en une plaque rigide, un tissu souple, un coussin d'épingles, un élément monté à ressort sur l'élément de maintien à dépression (6) et/ou est formé avec un côté de contact structuré et/ou au moins l'élément de distribution de courant (8b) et la structure formant contact (8a) sont formés d'un seul tenant, en particulier monolithiques.

8. Dispositif selon l'une des revendications précédentes,
**caractérisé en ce que**
l'élément de maintien à dépression comporte au moins un moyen d'étanchéité pour réduire, lorsque la pièce est disposée sur l'élément de maintien à dépression, le risque de pénétration d'électrolyte dans la surface de contact entre la deuxième électrode et la pièce.

9. Dispositif selon la revendication 8,
**caractérisé en ce que**
le produit d'étanchéité comporte un dispositif à gaz d'arrêt (11) qui est formé pour réduire au moyen d'un flux de gaz d'arrêt le risque de pénétration d'électrolyte dans la surface de contact entre la deuxième électrode (8) et la pièce (2).

10. Dispositif selon l'une des revendications précédentes,
**caractérisé en ce que**
le dispositif comprend un dispositif à gaz de lavage (14) pour dégager la surface de contact entre la pièce (2) et la deuxième électrode (8) avant et/ou pendant l'opération d'aspiration et/ou l'opération de gravure.

11. Procédé pour la gravure unilatérale d'une couche de semi-conducteur d'une pièce (2), dans lequel la couche de semi-conducteur est mouillée avec un électrolyte (3) d'un côté de gravure à graver,
l'électrolyte (3) est mis en contact électrique avec une première électrode (4), et la pièce (2) d'un côté opposé à l'électrolyte (3) avec une deuxième électrode, et
entre les électrodes est formé un courant de gravure,
**caractérisé**
**en ce que** pendant l'opération de gravure, la pièce (2) est maintenue uniquement d'un côté de maintien opposé au côté de gravure au moyen d'une dépression et pressée contre la deuxième électrode (8).

12. Procédé selon la revendication 11,
**caractérisé en ce que**
la pièce (2) est pressée contre la deuxième électrode (8) au moyen d'une dépression avec une pression dans la plage de 10 Pa à 50.000 Pa, de préférence dans la plage de 200 Pa à 2000 Pa et/ou
pendant l'opération de gravure, la deuxième électrode (8) réalise un contact à sec avec le côté de maintien de la pièce.

13. Procédé selon l'une des revendications 11 à 12,
**caractérisé en ce que** pendant l'opération de gravure, la deuxième électrode (8) réalise le contact avec une surface représentant au moins 80 %, en particulier au moins 95 % du côté de maintien de la pièce et/ou
la deuxième électrode (8) réalise le contact du côté de maintien de la pièce à une distance de bord dans la plage de 5 mm à 20 mm par rapport au bord de la pièce, en particulier à une distance de bord périphérique.

14. Procédé selon l'une des revendications 11 à 13,
**caractérisé en ce que**
du côté de gravure, une couche poreuse est créée par l'opération de gravure, en particulier une porosification a lieu et/ou le bord supérieur de la pièce est transporté au-dessous du niveau d'électrolyte.

15. Procédé selon l'une des revendications 11 à 14,
**caractérisé en ce que**
parallèlement à l'aspiration de la pièce (2) avec une dépression, l'agent de gravure est maintenu éloigné de l'électrode formant le contact par un gaz d'arrêt appliqué sur un bord de la pièce (2) sur la surface mise en contact avec la deuxième électrode.
